# EUROPÄISCHE PATENTANMELDUNG

(11) **EP 1 160 865 A2**
(43) Veröffentlichungstag der Anmeldung: **05.12.2001**
(21) Anmeldenummer: 01112173.8
(22) Anmeldetag: 17.05.2001
(51) Int. Cl.: H01L 23/525

(54) **Halbleiteranordnung mit optischer Fuse**

(30) Priorität: 30.05.2000 DE 10026926
(71) Anmelder: Infineon Technologies AG, 81669 München (DE)
(72) Erfinder: Benedix, Alexander, 81539 München (DE)
(74) Vertreter: Müller . Hoffmann & Partner Patentanwälte

(57) **Zusammenfassung**

Die Erfindung betrifft eine Halbleiteranordnung, bei der das Verpackungsmaterial (1) aus einem Material besteht, das für Strahlungsenergie durchlässig ist, welche das Material von Fuses (2), die an das Verpackungsmaterial (1) angrenzen, absorbiert.

## Beschreibung

Die vorliegende Erfindung betrifft eine Halbleiteranordnung mit einer optischen Fuse (Schmelzbrücke; "Sicherung"), die aus einem Material besteht, das Strahlungsenergie in wenigstens einem bestimmten Wellenlängenbereich zu absorbieren vermag, und mit einem Verpackungsmaterial, an das die optische Fuse mindestens teilweise angrenzt.

Optisch programmierbare Fuses werden in letzter Zeit u. a. bevorzugt in Halbleiterspeicheranordnungen eingesetzt, in welchen sie beispielsweise zur Aktivierung von redundanten Elementen in einem Wafertest verwendet werden. In einem solchen Wafertest werden z. B. fehlerhafte Speicherzellen ermittelt und durch Brennen von Fuses oder auch Antifuses durch redundante Speicherzellen ersetzt.

Nachdem Halbleiteranordnungen die "Waferebene" verlassen haben und, um bei dem Beispiel von Halbleiterspeicheranordnungen zu bleiben, als Speicherbausteine in Gehäusen verpackt sind, ist es derzeit nicht möglich, fehlerhafte oder schwache Speicherzellen auf Bausteinebene durch Brennen von Fuses zu reparieren bzw. durch redundante Speicherzellen zu ersetzen.

Aus diesem Grund werden Bausteine, die in einem Endtest auf Bausteinebene ("Backend-Test") Fehler aufzeigen, wie beispielsweise eine Drift nach einem Burn-In (Belastungstest), verworfen. Mit anderen Worten, eine Reparatur von Halbleiteranordnungen auf Bausteinebene ist bisher mit optischen Fuses nicht möglich.

Es ist daher Aufgabe der vorliegenden Erfindung, eine Halbleiteranordnung mit einer optischen Fuse zu schaffen, welche auch auf Bausteinebene durch Brennen der Fuse reparierbar sein soll.

Diese Aufgabe wird bei einer optischen Fuse der eingangs genannten Art erfindungsgemäß dadurch gelöst, daß das Verpackungsmaterial für die Strahlungsenergie mindestens teilweise in dem bestimmten Wellenlängenbereich durchlässig ist. Unter Verpackungsmaterial ist dabei ganz allgemein beispielsweise auch der Halbleiterkörper bzw. das Substrat oder ein Träger der Halbleiteranordnung zu verstehen.

Mit anderen Worten, bei der erfindungsgemäßen Halbleiteranordnung absorbiert also die Fuse Strahlungsenergie in einem anderen Wellenlängenbereich als das Verpackungsmaterial der Halbleiteranordnung.

Beispielsweise besteht bei Rambus CSP (Rambus = DRAM-Architektur, wie beispielsweise SDRAM; CSP = Chip Size Package) die Rückseite des Gehäuses (bzw. Package) aus dem blanken Silizium des die Halbleiteranordnung enthaltenden Chips. Für die auf der Vorderseite des Chips angeordneten Fuses wird dann ein Material gewählt, das Strahlungsenergie in einem für das Gehäusematerial, also im vorliegenden Beispiel Silizium, transparenten Bereich absorbiert. Für dieses Material sind z. B. A_{III}B_{V}-Halbleitermaterialien geeignet. Besonders vorteilhaft ist InGaAsP als Fusematerial, wenn das Verpackungsmaterial durch den Chip der Halbleiteranordnung gebildet wird. Ebenso sind für die Fuses auch andere Materialien geeignet, wie z. B. Metalle, Standard-Legierungen, sonstige Legierungen, Germanium, PbS, InSb, SiGe usw. Beispiele sind Standard-Metallisierungen von integrierten Schaltungen auf Wolfram- oder Aluminium-Basis, Kupfer und Titansilizid.

Silizium weist einen ab etwa 950 nm Wellenlänge stark abnehmenden Absorptionskoeffizienten für Strahlungsenergie auf und ist im Bereich ab 1050 nm Wellenlänge nahezu transparent.

Wird für die Strahlungsenergie ein Laser mit einer Wellenlänge von etwa 1350 nm eingesetzt, so durchdringt die Laserstrahlung nahezu ungehindert das Silizium des Chips. Strahlung im Bereich mit einer Wellenlänge von 1350 nm wird aber durch sämtliche A_{III}B_{V}-Halbleitermaterialien hervorragend absorbiert, so daß aus diesen A_{III}B_{V}-Halbleitermaterialien bestehende Fuses durch Einwirkung von Laserstrahlung gebrannt werden können.

Die Erfindung schafft so die Möglichkeit, Halbleiteranordnungen auf Bausteinebene in einem Endtest nach ihrer Verpackung durch Brennen von Fuses zu reparieren, wenn in einem Endtest Fehler festgestellt werden. Dies wird dadurch erreicht, daß für die Verpackung des Bausteins, also das Gehäuse der Halbleiteranordnung, Materialien verwendet werden, welche für Strahlungsenergie durchlässig sind, während die für die Reparatur herangezogenen Fuses aus Materialien bestehen, die gerade die Strahlungsenergie absorbieren, welche von der Verpackung durchgelassen wird.

Die Erfindung ist in bevorzugter Weise auf Halbleiterspeicheranordnungen anwendbar. Selbstverständlich kann die Erfindung aber auch bei anderen Halbleiteranordnungen in zweckmäßiger Weise eingesetzt werden, bei denen durch Brennen einer Fuse redundante Bauelemente eingeschaltet werden, um gegebenenfalls fehlerhafte Bauelemente zu ersetzen.

Die Fuse muß bei der erfindungsgemäßen Halbleiteranordnung so vorgesehen sein, daß sie durch das Verpackungsmaterial wenigstens teilweise für die von außen auf die Halbleiteranordnung einwirkende Strahlungsenergie zugänglich ist. Dies kann dadurch geschehen, daß die Fuse auf der Oberseite eines Halbleiterchips vorgesehen wird, dessen Siliziumkörper selbst die Verpackung bildet.

Selbstverständlich ist die vorliegende Erfindung aber auch auf andere Gestaltungen der Verpackung anwendbar: entscheidend ist allein, daß die Verpackung für Strahlungsenergie durchlässig ist, welche von der Fuse absorbiert wird, und daß die Strahlungsenergie über die Verpackung auf die Fuse einwirken kann.

Es sei noch angemerkt, daß unter "Verpackung" ein Gehäuse im allgemeinen Sinn zu verstehen ist, das die Halbleiteranordnung, d. h. die in dieser enthaltene integrierte Schaltung, schützt. Im obigen Beispiel wird die Verpackung durch den Chip selbst gebildet.

Die Verpackung kann auch auf einem Modul aufgelötet sein, wie beispielsweise bei einem RIMM (Rambus-Inline-Memory-Modul). Entscheidend ist allein, daß die Fuses für Strahlungsenergie durch die Verpackung zugänglich bleiben und diese Strahlungsenergie zu absorbieren vermögen.

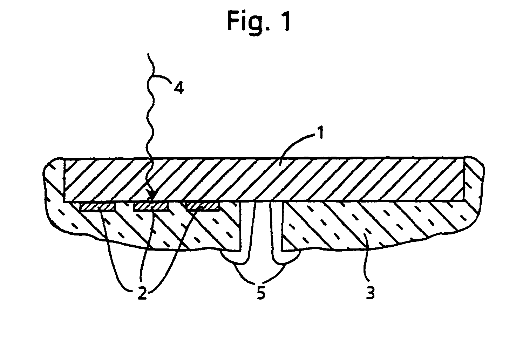

Nachfolgend wird die Erfindung anhand der Zeichnung näher erläutert, in deren einziger Figur eine Halbleiteranordnung gezeigt ist.

Ein Halbleiterkörper 1 aus Silizium enthält eine Halbleiterspeicheranordnung auf seiner Oberseite (in der Figur unten). Eine solche Halbleiterspeicheranordnung kann beispielsweise ein DRAM oder ein SDRAM sein.

Außerdem sind auf der die Halbleiterspeicheranordnung aufweisenden Seite des Halbleiterkörpers 1 noch Fuses 2 vorgesehen. Diese Fuses 2 bestehen aus InGaAsP. Die Fuses und die die Halbleiterspeicheranordnung aufweisende Seite des Halbleiterkörpers 1 sind in ein Chipgehäuse 3 aus einem geeigneten Isolierstoff, beispielsweise Epoxidharz, eingebettet. Bonddrähte 5 können aus diesem Epoxidharz herausragen und für äußere Verbindungen sorgen.

Das Silizium des Halbleiterkörpers 1 ist, wie bereits oben erwähnt wurde, für Strahlungsenergie im Wellenlängenbereich über etwa 1050 nm praktisch transparent. Entsprechend kann ein Laserstrahl 4 mit einer Wellenlänge von etwa 1350 nm das Silizium des Halbleiterkörpers 1 praktisch ungestört durchsetzen und so von der Rückseite des Halbleiterkörpers 1 her die Fuses 2 erreichen. Da die Fuses 2 aber aus InGaAsP bestehen, welches Strahlungsenergie mit 1350 nm absorbiert, können sie durch den Laserstrahl 4 gezündet werden.

Selbstverständlich können für die Verpackung auch andere Materialien als das Silizium des Halbleiterkörpers 1 herangezogen werden. Gleiches gilt auch für die Fuses: diese können auch aus anderen A_{III}B_{V}-Halbleitermaterialien als InGaAsP bestehen. Außer A_{III}B_{V}-Halbleitermaterialien können für die Fuses 2 auch andere Materialien verwendet werden, sofern diese Strahlungsenergie absorbieren, welche von dem Verpackungsmaterial durchgelassen wird.

## Patentansprüche

1. Halbleiteranordnung mit einer optischen Fuse (2), die aus einem Material besteht, das Strahlungsenergie in wenigstens einem bestimmten Wellenlängenbereich zu absorbieren vermag, und mit einem Verpackungsmaterial (1), an das die optische Fuse mindestens teilweise angrenzt,
**dadurch gekennzeichnet,**
**daß** das Verpackungsmaterial für die Strahlungsenergie mindestens teilweise in dem bestimmten Wellenlängenbereich durchlässig ist, und
**daß** die Fuse (2) aus einem A_{III}B_{V}-Halbleitermaterial oder aus Titansilizid, Germanium, PbS, InSb oder SiGe besteht.

2. Halbleiteranordnung nach Anspruch 1,
**dadurch gekennzeichnet,**
**daß** das Verpackungsmaterial aus dem Halbleiterkörper bzw. Substrat oder Träger der Halbleiteranordnung besteht.

3. Halbleiteranordnung nach Anspruch 2,
**dadurch gekennzeichnet,**
**daß** der Halbleiterkörper aus Silizium besteht.

4. Halbleiteranordnung nach einem der Ansprüche 1 bis 3,
**dadurch gekennzeichnet,**
**daß** das A_{III}B_{V}-Halbleitermaterial InGaAsP ist.
